# EUROPEAN PATENT APPLICATION

(11) **EP 1 498 934 A2**
(43) Date of publication of application: **19.01.2005**
(21) Application number: 04019924.2
(22) Date of filing: 28.02.1997
(51) Int. Cl.: H01L 21/00, B25J 19/00, B24B 37/04

(54) **Robotic wafer transport apparatus**

(30) Priority: 28.02.1996 JP 6926096; 15.10.1996 JP 29454396; 22.01.1997 JP 2435797
(62) Divisional of application: 97103376.6
(71) Applicant: EBARA CORPORATION, Ohta-ku, Tokyo (JP)
(72) Inventor: Togawa, Tetsuji, Chigasaki-shi Kanagawa-ken (JP); Yamaguchi, Kuniaki, Yokohama-shi Kanagawa-ken (JP); Sakurai, Kunihiko, Yokohama-shi Kanagawa-ken (JP)
(74) Representative: Wagner, Karl H., Dipl.-Ing.

(57) **Abstract**

A robotic transport apparatus capable of providing an effective waterproof function for working components in the system without using mechanical seals is disclosed. The robotic transport apparatus comprises: a robot body; an arm assembly extendably attached to the robot body; and a workpiece holding section attached to the arm assembly. A pan member for waterproof of the robot body is provided between the workpiece holding section and the robot body and has a projection area not smaller than the workpiece holding section.

## Description

### BACKGROUND OF THE INVENTION

### Field of the Invention

The present invention relates to a robotic transport apparatus suitable for transporting workpieces in a semiconductor device manufacturing system, for example, including wet and/or dirty processes such as a CMP (chemical mechanical polishing) system.

### Description of the Related Art

In a semiconductor wafer manufacturing process, a polishing apparatus is commonly used to provide a flat mirror polished surface on the wafers. Such a polishing apparatus comprises a turntable and a top ring independently rotated to each other, and the wafers held on the underside of the top ring are polished by pressing the wafer against a polishing surface provided at the top surface of the turntable while supplying an abrasive liquid onto the surface. The polishing apparatus also includes a wafer storage unit for placing a cassette including wafers to be polished, a cleaning unit for cleaning and drying the polished wafers, and a transport apparatus for transporting the wafers between the processing units.

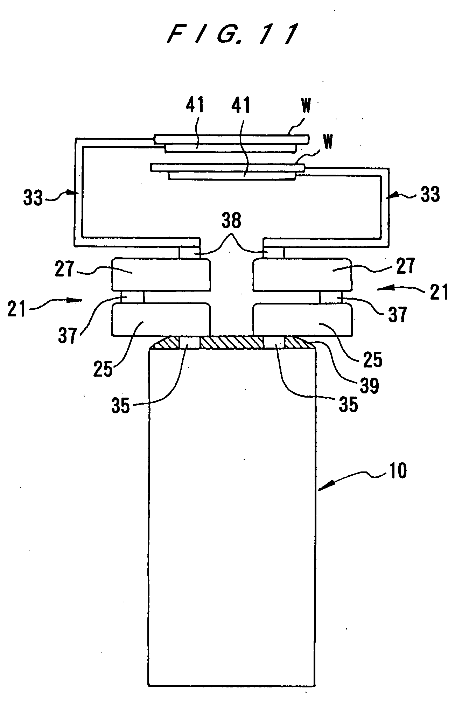

An example of such transport apparatus is shown in Figure 11. The apparatus comprises a cylindrical robot body 10 having a set of arm devices 21 disposed on the top surface of the robot body 10. The arm device 21 comprises two arms 25, 27 having articulating joint sections 35, 37, and the upper arm 27 is provided with a hand member (workpiece holding section) 41 disposed at the tip end of a connection member 33 through an articulating joint section 38.

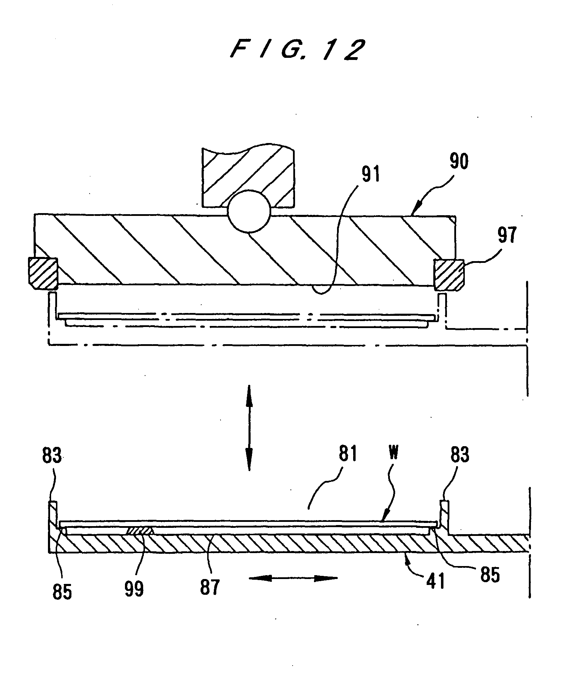

An example of the configuration of a hand device is shown in Figure 12. The hand member 41 is substantially of a plate shape and has a recess in its central region serving as a receiving section 81 which is surrounded with protruding guides 83. The receiving section 81 comprises a wafer contact surface 85 for abutting the lower surface edges of the wafers W, and a bottom section surface 87 which is disposed on the inside of the wafer contact surface 85 at a lower level than the wafer contact surface 85. On the other hand, the top ring 90 is of a circular shape, and is provided with a vacuum suction surface 91 at the bottom surface and a guide ring 97 attached to its periphery.

To transfer the wafer W from the top ring 90 to the hand member 41 using such an arrangement, the hand member 41 is placed directly below the top ring 90 holding the wafer W by vacuum suction, and then the vacuum hold on the wafer is released by shutting off the vacuum suction so that the wafer W will drop into the receiving section 81 of the hand member 41. This action is illustrated by designating the hand member 41 with a single dot lines in the top drawing in Figure 12. After dropping the wafer W, the hand member 41 is moved away downwards.

This type of robotic transport apparatus is used to transport the wafers W to various processing apparatuses for various processing steps, such as polishing and cleaning steps, by means of the connection member 33. The wafers are often dripping with processing liquid, and in transporting wet wafers, liquid droplets falling from the wafers often accumulate on the top surface of the robot body 10.

When the quantity of liquid droplets increases to fill the gap surrounding the articulating joint section 35, as illustrated by shaded areas in Figure 11, the liquid can penetrate into the arm 25 and robot body 10 through the crevices in the joint section 35. Such seepage of liquid leads to corrosion of the mechanisms to generate malfunctioning of the working parts, leading to increased requirements for maintenance. Such operational problems lower the cost performance ratio of the apparatus and leads to productivity loss. The same problems occur when the liquid seeps into joint sections 37, 38.

To prevent such seepage of liquid, a usual practice is to use mechanical seals, however, such contact seals have still some clearance and are not totally water tight, and it has been extremely difficult to prevent such liquid seepage into critical operating components of the apparatus.

Furthermore, when O-ring, which is known to provide effective contact sealing, is used to seal joint section 35, 37 or 38, although the seepage clearance is reduced by the strong elastic sealing force of the O-ring, the local frictional forces are increased owing to the large frictional force exerted by the compressed O-ring. The result is a drop in the operational speed of the arms 25, 27. On the other hand, if the speed of the arms 25, 27 is to be maintained, it is necessary to provide a larger torque for arm rotation, thus generating a problem of need for a driving motor with a larger driving capacity.

Also, the conventional design of the guide member 83 is such that the upper edge is formed at right angles to the guide, and if there is a misalignment between the top ring 90 and the hand member 41, the outer periphery of the wafer W can easily become lodged in the angular section of the guide 83, thus preventing the wafer W from being safely deposited within the receiving section 81.

Another problem with the existing design of the robotic transport apparatus for handling the wafers is that the bottom section surface 87 of the hand member 41 often becomes contaminated with droplets of liquid from sources such as abrasive liquid. Droplets 99 forms spheres due to the surface tension on the bottom section surface 87 as illustrated in Figure 12, and its diameter may exceed the separation distance between the wafer contact surface 85 and the bottom section surface 87 which is now set only about 1.5 mm. Therefore, the droplet 99 could easily grow to contact the surface of the wafer W. It can be seen that if a hand member 41, having such large droplets 99 of abrasive liquid, is used to pickup a wafer W from a cleaning device, it can lead to a problem that the cleaned wafer has now become contaminated with the substances in the abrasive liquid.

### SUMMARY OF THE INVENTION

It is therefore an object of the present invention to provide a robotic transport apparatus which can provide an effective waterproof function for working components in the system without using mechanical seals.

It is another object of the present invention to provide a robotic transport apparatus which can: safely receive the workpieces into a receiving section of a hand member to assure stable transportation of the workpieces; eliminate the possibility of contaminating the wafers by the liquid abiding at the hand member; and also lighten the hand member.

The object has been achieved in a robotic transport apparatus comprising: a robot body; an arm assembly extendably attached to an upper surface of the robot body; and a workpiece holding section attached to the arm assembly, wherein a pan member for waterproof having a projection area not smaller than the workpiece holding section is provided between the workpiece holding section and the robot body.

Accordingly, transfer of liquid from the workpieces to the robot body and seepage of liquid into the joint sections of the arm assembly have been prevented so as to provide a stable operation and a long service life of the system.

In another aspect of the transport apparatus, the arm assembly may be provided with a connection member for connecting to the workpiece holding section in a manner to bypass the pan member. The pan member may be provided with a drainage pipe to remove the waste liquid. The transport apparatus may be provided with a driving mechanism to enable the device to move along a transport path, and a trench alongside the transport path so that the waste liquid may be removed therethrough.

In another aspect of the invention, a transport apparatus comprises: a robot body; an arm assembly extendably attached to an upper surface of the robot body; and a workpiece holding section attached to the arm assembly, wherein the workpiece holding section has a receiving section of a recessed configuration for receiving workpieces, and the receiving section comprises a contact surface for contacting lower peripheral surfaces of the workpieces and a bottom section surface disposed on an inner side of and at a lower level than the contact surface, and a separation distance between the contact surface and the bottom section surface is selected to be not less than a maximum diameter of a droplet formed by a liquid abiding at the bottom section surface. The separation distance should be designed so that it is wider than 3 mm.

### BRIEF DESCRIPTION OF THE DRAWINGS

Figure 1 is an overall plan view of an embodiment of the polishing apparatus of the present invention.
Figure 2 is a perspective view of the flow of processed wafers being transported by the robotic transport apparatus of the present invention.
Figure 3 is a cross-sectional view of the robotic transport apparatus of the present invention.
Figure 4 is a perspective view of the robotic transport apparatus of the present invention.
Figure 5 is a perspective view of the hand member.
Figure 6 is a cross-sectional view of the hand member through a plane A-A in Figure 5.
Figure 7 is a cross-sectional view of another embodiment of the hand member of the present invention at its bottom section.
Figure 8 is a cross-sectional view of another embodiment of the hand member.
Figure 9 is a schematic drawing of the chuck mechanism and the hand member.
Figure 10 is a schematic drawing showing the robotic transport apparatus having a hand member and a waterproof pan member.
Figure 11 is a schematic side view of a conventional robotic transport apparatus.
Figure 12 is an illustration of the process of transfer of a wafer between the top ring and the hand member in a conventional robotic transport apparatus.

### DESCRIPTION OF THE PREFERRED EMBODIMENTS

In the following, preferred embodiments will be explained with reference to the drawings.

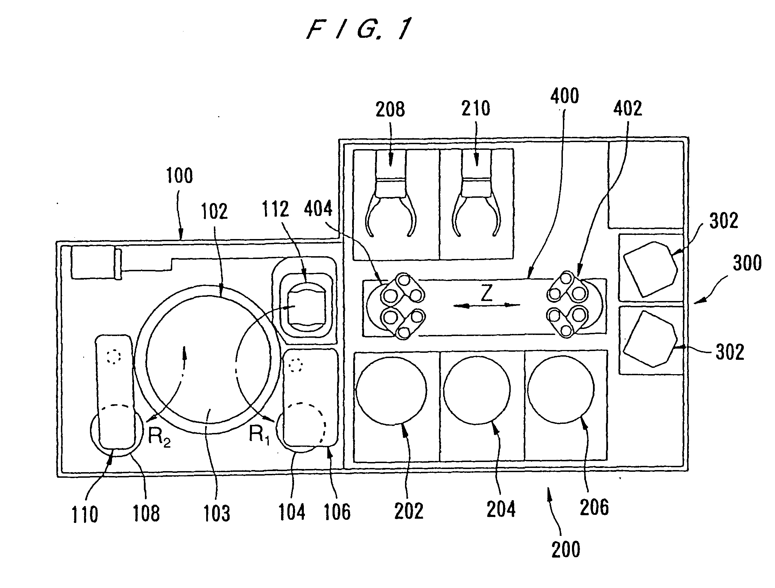

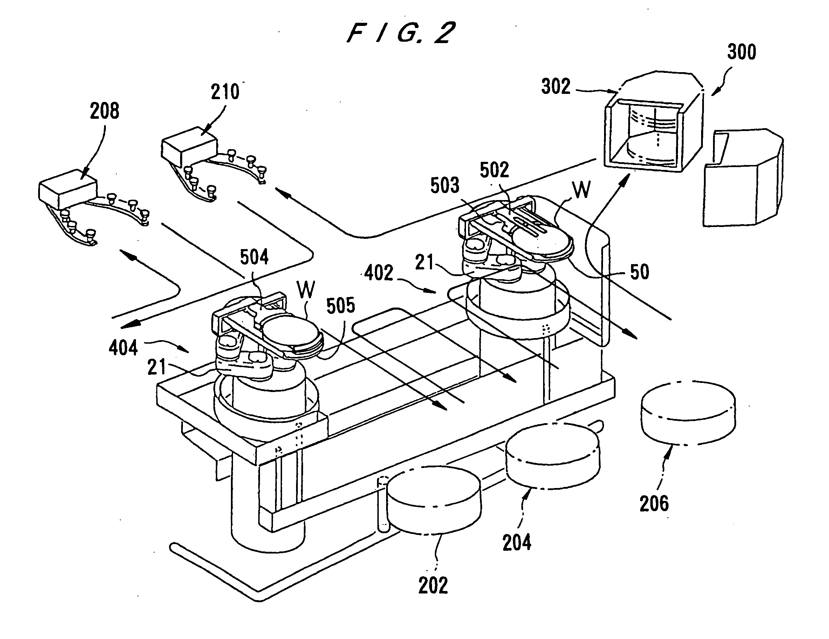

As shown in Figures 1 and 2, the polishing apparatus comprises: a polishing section 100; a cleaning section 200; a storage section 300 for storing wafers W; and a transport apparatus 400 having two robotic transport apparatuses 402, 404 for transporting wafers W.

The polishing section 100 comprises: a turntable 102, a polishing unit 106 having a top ring 104 and a dressing unit 110 having a dressing tool 108; and a workpiece handling unit 112.

The cleaning section 200 comprises: a primary and secondary cleaning devices 202, 204 and spin dryers (which may have washing capability) 206 disposed in a side-by-side arrangement on one side of the centrally disposed transport apparatus 400; and a wet workpiece turning device 208 and a dry workpiece turning device 210 disposed in a side-by-side arrangement on the other side of the transport apparatus 400.

Figure 2 shows a perspective view of essential parts of the transport apparatus 400 and the cleaning section 200. As shown in the drawing, robotic transport apparatuses 402, 404 are each provided with two sets of arm assemblies 21. At the tip of each arm assembly 21 are provided hand members (workpiece holding section) 502, 503 and 504, 505 for holding wafers W. The hand members 502, 503 and 504, 505 are arranged so that top hand member 502 superimposes the bottom hand member 503 and likewise for the other set of top and bottom hand members 504, 505.

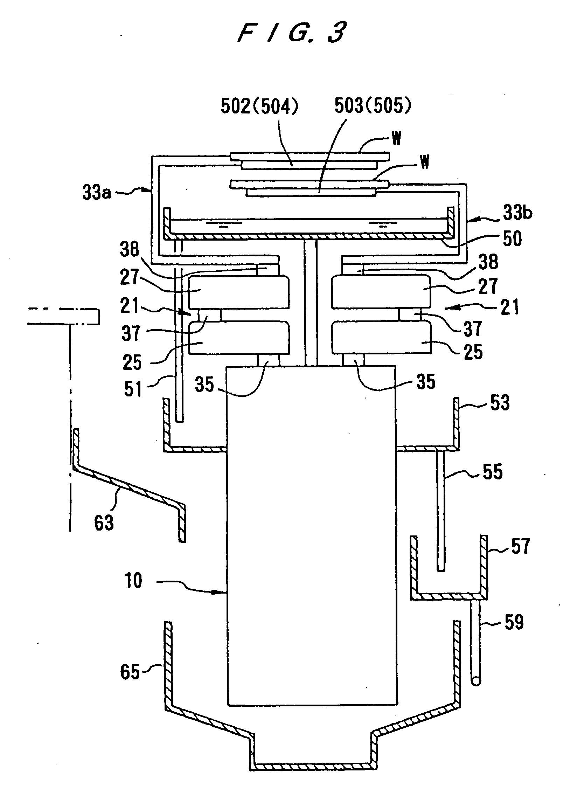

As shown in Figure 3, a cross-sectional view of the robotic transport apparatuses 402, 404, each of the arm assemblies 21 comprises two arms 25, 27 connected together respectively with articulating joint sections 35, 37. Substantially U-shaped connection members 33a, 33b are joined to the arms 27, and plate-shaped hand members 502 (504), 503 (505) for holding the wafers W are provided at the tips of the connection members 33a, 33b by way of an articulating joint section 38. Therefore, the hand members 502 (504), 503 (505) are connected to the arms 27 in a manner to bypass a waterproof pan member 50 which will be described hereinafter, i.e., each of the hand members 502 (504), 503 (505) is located in the same position in a horizontal projection as the tip of the arm 27 or the articulating joint section 38. The hand members 503 (505), 502 (504) are provided at the tip of each of the connection members 33a, 33b so that they superimpose vertically without touching each other. Each of the hand members 503 (505), 502 (504) holds a wafer W on its upper surface.

In this embodiment, the connection member 33b is disposed below the connection member 33a, and a waterproof pan member 50 is provided between the articulating joint section 38 and the hand member 503 (505) attached to the lower connection member 33b. The size of the waterproof pan member 50 is chosen so that the length and width dimensions are larger than the diameter of the wafer W which is being held in the connection members 33a, 33b. Thus, a projection a horizontal plane of the waterproof pan member 50 covers that of the hand member 503 (505). In this embodiment in particular, the length and width dimensions of the pan member 50 are larger than the diameter of the robot body 10, and consequently, they are larger than the hand members 503, 504 or 505 which serve as the workpiece holding sections. Also, the waterproof pan member 50 is made so as to extend at right angles to the transport path Z, in other words, the waterproof pan member 50 is disposed so as to guard the entire area of movement of the wafer W above the robot body 10.

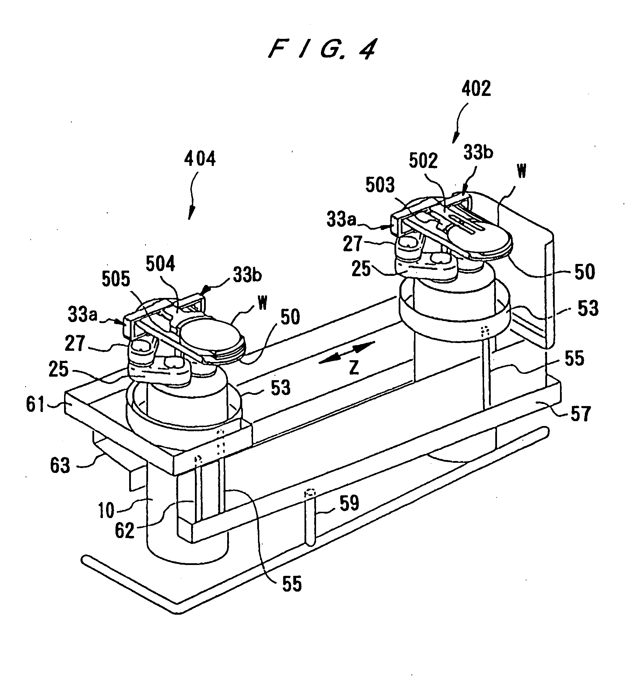

As shown in Figures 3 and 4, a drainage pipe 51 is connected to a certain location of the waterproof pan member 50, and the bottom end of the drainage pipe 51 is inserted into a second waterproof pan member 53 of a ring shape arranged about the outer periphery of the robot body 10. The pan member 50 should be disposed at an incline to tilt towards the location of attachment of the drainage pipe 51 so as to facilitate draining of water. The second pan member 53 is also provided with a drainage pipe 55 whose bottom end is inserted into a trench 57.

The robotic transport apparatuses 402, 404 are constructed so that they can move towards various processing locations, such as the polishing section 100 and the cleaning section 200, by proceeding in the direction Z shown by an arrow in the drawing. The trench 57 is formed, as shown in Figure 4, over the entire length of movement of the robot along one side of the two robotic transport apparatuses 402, 404. The trench 57 is also provided with a drainage pipe 59.

A third waterproof pan member 61 is provided on the left side of the robotic transport apparatus which is seen on the left in Figure 4 (omitted in Figure 3), and a drainage pipe 62 provided on the third pan member 61 is inserted into the trench 57. Opposite to the trench 57, a fourth waterproof pan member 53 is provided over the entire length of movement of the robotic transport apparatus, and a fifth waterproof pan member 65 is provided below the robot body 10, as shown in Figure 3 (omitted in Figure 4).

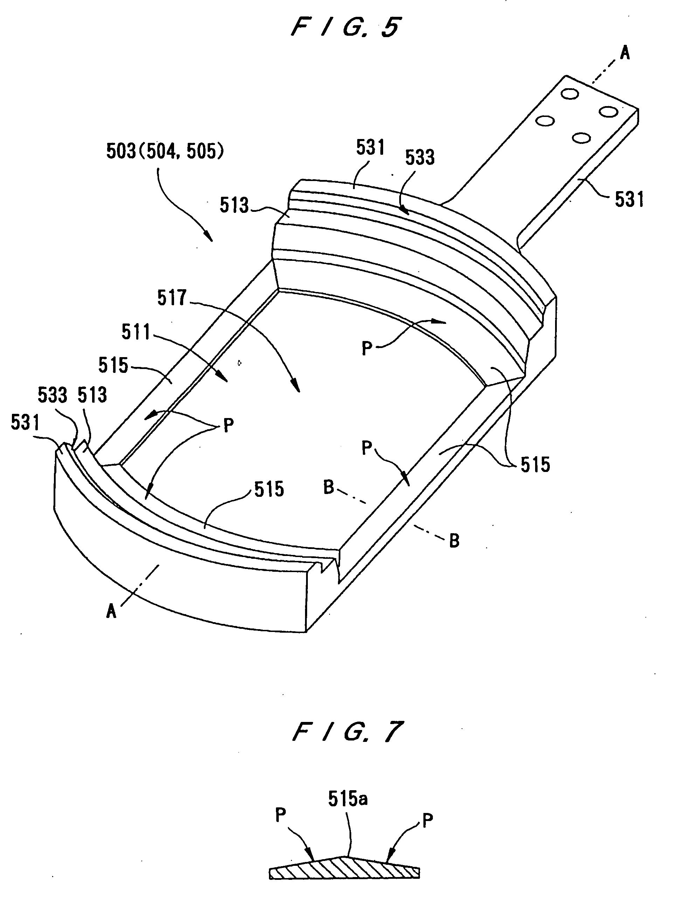

The hand member 502 has a vacuum suction mechanism to hold the wafers W thereon since it is used to handle only dry wafers W, while all the other hand members 503, 504 and 505 (all represented by 503 hereinbelow) are for handling wet wafers W wetted by liquids such as polishing, rinsing or cleaning liquid. The wet workpiece hand members 503 have a shelf shaped tray for receiving the workpiece at the periphery thereof. As shown in Figure 5, the hand members 503 is constructed such that a receiving section 511 of a depression shape for storing circular shaped wafers W is formed in the center region of the hand member 503, which is provided with outer guide portions 531 surrounding the receiving section 511 and a handle portion 551 protruding therefrom.

The receiving section 511 is comprised of: two arc shaped contact surfaces 513 for abutting the outer periphery of the wafer W; a bottom section surface 515 having a lesser height than the contact surfaces 513 disposed between the two contact surfaces 513; and an oval shaped drainage opening 517 disposed centrally in the bottom section surface 515. Every region of the bottom section surface 515 is made so as to slope towards the drainage opening 517 to serve as the tapered drainage surface P for liquid drainage.

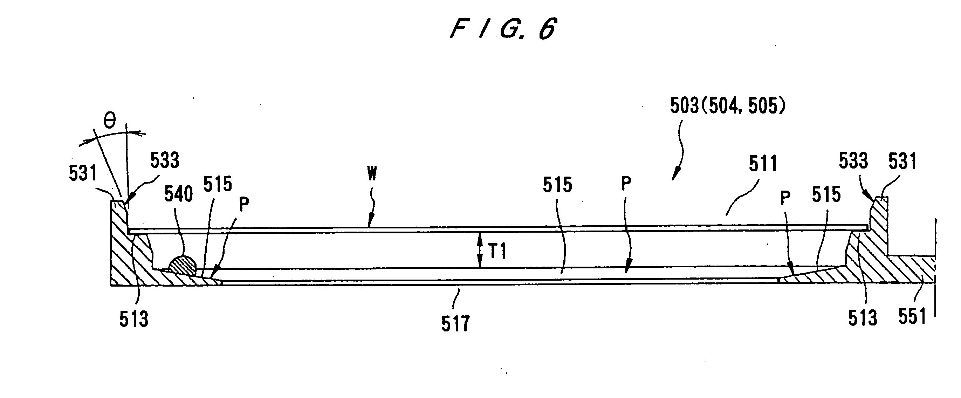

The height difference T1 (refer to Figure 6) between the contact surfaces 513 and the highest point on the bottom section surface 515 is such that this value T1 is larger than the maximum dimension of a liquid droplet grown by the surface tension effects and abiding at the bottom section surface 515. In this embodiment, the design has adopted a height dimension T1 to be larger than 6 mm.

On the other hand, the upper inside edge of the guide portions 531 has a tapered guide surface 533 progressively retreating toward the upper direction. The taper angle θ of the guide surface 533 should not be too large for the wafer W to slide down along the guide surface 533, so a preferred angle would be about 20 degrees.

To prevent corrosion on the hand member 503 or metallic contamination of the wafer W, the hand member 503 made of a metal plate (for example, aluminum or SUS plate) is coated with a polymeric coating material. Instead of applying a polymeric coating, it is also permissible to attach a polymer part prepared separately to the hand member 503 for constructing the regions of direct contact with the water W, i.e., the inside surfaces including the guide surface 533 of the guide portion 513 and the contact surface 513. The handle portion 551 is attached to the tip of the connection members 33a, 33b.

The overall operation of the polishing apparatus will be explained with reference to Figures 1 and 2. The hand members 502 to 505 of the robotic transport apparatus 402 are made independently extendable in shelf and vertical directions. When the cassette 302 containing the pre-polishing wafers W is placed in the location shown in the drawings, the hand member 502 of the robotic transport apparatus 402 removes a wafer W at a time from the cassette 302 and hands it over to the workpiece turning device 210 which turns over the wafer W. From the turning device 210, the wafer W is passed onto the hand member 504 of the transport apparatus 404, and is transported to the workpiece delivery device 112 of the polishing section 100.

The wafer W on the workpiece delivery device 112 is transferred onto the bottom surface of the top ring 104 of the polishing unit 106 (which swings in the direction of the arrow R₁ shown in the drawing) and is positioned on the turntable 102, and is polished by the rotating polishing surface 103. The polishing surface 103 is supplied with an abrasive liquid through a supply pipe (not shown) during the polishing operation.

The polished wafer W is again returned to the workpiece delivery device 112, and is again transferred to the workpiece turning device 208 by the hand member 505 of the robotic transport apparatus 404 and is turned over while being rinsed with a rinsing liquid. The wafer W is then transported to the primary cleaning device 202 by the hand member 505 to be cleaned, then onto the secondary cleaning device 204 by the hand member 504 to be cleaned, and is transported to the spin dryer 206 by the hand member 503 to be dried therein, and is returned to the original cassette 302 by the hand member 502.

The dressing unit 110 shown in Figure 1 is used to dress the polishing surface 103 by moving onto the turntable in the direction of arrow R₂ and by pressing the dressing tool 108 onto the rotating polishing surface 103.

In this arrangement of the polishing apparatus, the fork-shaped hand member 502 is used only to handle dried wafers W, and all other wafers W wet with polishing, rinsing or cleaning liquid are handled with the hand members 503-505, each of which has a drip tray. This arrangement prevents the wafers W from being contaminated through the use of the hand members 502-505.

In the above steps, when the wafers W are handled by the hand members 503-505 in the polishing section 100 or in the cleaning section 200, the liquid from the wet wafers W will drip down, but the robot body 10 is completely protected from becoming wet by the first waterproof pan member 50, thus preventing the drips to fall onto the upper surfaces of the robot body 10 and the arms 25, 27. Therefore, there is no danger of liquid seeping from the articulating joint sections 35, 37 and 38 into the arms 25, 27 or into the robot body 10.

The liquid droplets falling onto the pan member 50 are collected in the trench 57 after passing through the drainage pipe 51 and the second waterproof pan member 53, and are discarded externally through the drainage pipe 59. The second pan member 53 not only performs the function of guiding the liquid droplets falling on the pan member 50 to the trench 57, but also performs the function of collecting the droplets even when the droplets which should have fallen into the pan member 50 are accidentally scattered about the robot body 10 by some event such as vibration, for example.

When handling the wafers W in the polishing section 100 or in the cleaning section 200, the wafers W extend out of the pan member 50, but the droplets which fall from the wafers W are collected in the third and fourth pan members 61, 63 and in the trench 57, and are drained through the drainage pipe 59 and the fifth pan member 65 (refer to Figure 3).

It can be seen from the presentation above that the first and second pan members 50 and 53 are primarily aimed at preventing the droplets to fall onto the workpiece transport apparatuses, and the third, fourth and fifth pan members 61, 63 and 65 are primarily aimed at preventing the droplets from falling onto the facilities and devices while the wafers W are being handled between the wafer transport apparatuses and wafer processing devices. The water removal means such as trench 57 are used commonly in either occasions. Each pan or trench may be formed to have a tapered cross section widening towards the upper opening to facilitate water inflow.

Next, the role of the hand members 503-505 will be explained. When the wafer W held by the top ring 90 shown in Figure 12, for example, is to be dropped into the hand member 505, the hand member 505 is brought directly below and adjacent to the top ring 90 holding the wafer W. The vacuum on the top ring 90 is then released so that the wafer W may be dropped into the receiving section 511 of the hand member 505.

When the wafer W is dropped, even if the top ring 90 and the hand member 505 happens to be misaligned, the wafer W can slide down safely into the receiving section 511, by having the outer periphery of the wafer W guided by the guide surface 533 provided on the guide portion 531, without a danger of the wafer W being stuck at the upper edge of the guide portion 531.

It can be understood that the droplets from the abrasive liquid and water used in polishing the wafer W adhere to the top ring 90, and they may easily fall onto the hand member 505 and collect on its upper surface. However, as illustrated in Figure 6, the hand member 505 is designed so that even when the largest droplets 540 is formed, the clearance provided by the separation distance T1 between the bottom section surface 515 and the contact surface 513 is larger than the height dimension of the droplet 540, and there is no danger of the droplet 540 touching the bottom region of the wafer W.

It should further be noted that because the bottom section surface 515 serves as the tapered drainage surface P for liquid removal, the droplets 540 attached to the bottom section surface 515 slide along the tapered surface P to be removed by falling through the drainage opening 517. Furthermore, because of the presence of the drainage opening 517, the area of the bottom section surface 515 itself for receiving the droplets falling from the top ring 90 and wafers W becomes small, and little water remains on the bottom section surface 515. Even if the droplets 540 should grow to a large size, there is no danger of the wafer W touching the droplet 540, thus totally preventing contamination of the wafer W by potentially harmful liquid. Further, the hand member 505 is provided with the drainage opening 517, and weight reduction of the hand member can be achieved. The droplets dripping from the opening 517 or circumference about the hand member 505 run into the waterproof pan 50, 53 described above.

It is clear that the beneficial effects of the design and arrangement of the hand members in transferring the wafers W from the top ring apply equally in the case of transferring the wafers W or handling wafers W in other devices, such as the wafer turning device and spin dryers.

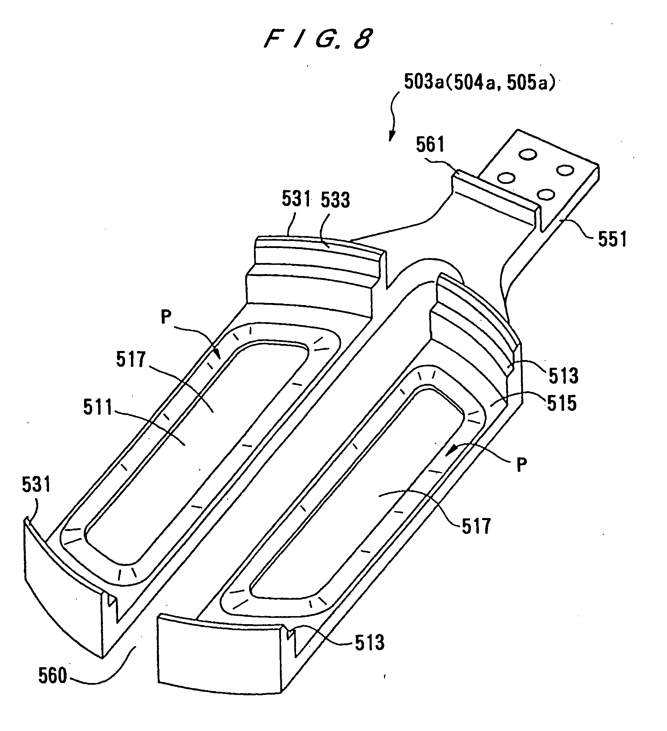

Figure 7 is a cross-sectional view of another embodiment of the hand member, which is a corresponding view to that through a plane B-B of the bottom section surface shown in Figure 5. As shown in this drawing, the bottom section surface 515a comprises a central high region and tapered drainage surfaces P for removing liquid. This configuration provides the same advantages as those described in the previous embodiment. It is obvious that the shape of the receiving section, tapered drainage surface P and openings presented in the previous embodiment are only illustrative examples, and they can be designed in many different ways to achieve the same purpose.

Figures 8 to 10 show a perspective view of another embodiment of the hand member 503a of the present invention. The parts of this hand member 503a which are the same as or similar to those shown in the hand member 503 in Figure 5 are given the same reference numerals, and their detailed explanations will be omitted. The differences between the hand members shown in Figure 5 and Figure 8 are that the receiving section 511 of the hand member 503a has a longitudinal cut-out 560, and a protrusion section 561 on the upper surface of the handle portion 551. The presence of the cut-out 560 causes the drainage opening 517 to be split into two sections, and each of the openings 517 is provided with a tapered drainage surface P.

According to the hand member presented in Figure 8, in addition to the benefits associated with the hand member shown in Figure 5, the following advantages are obtained. The cut-out 560 reduces the area of the contact surface 513, thereby reducing the area of contact of the surface 513 with the wafers W, thereby further reducing the sites of potential of contamination sources such as dust particles.

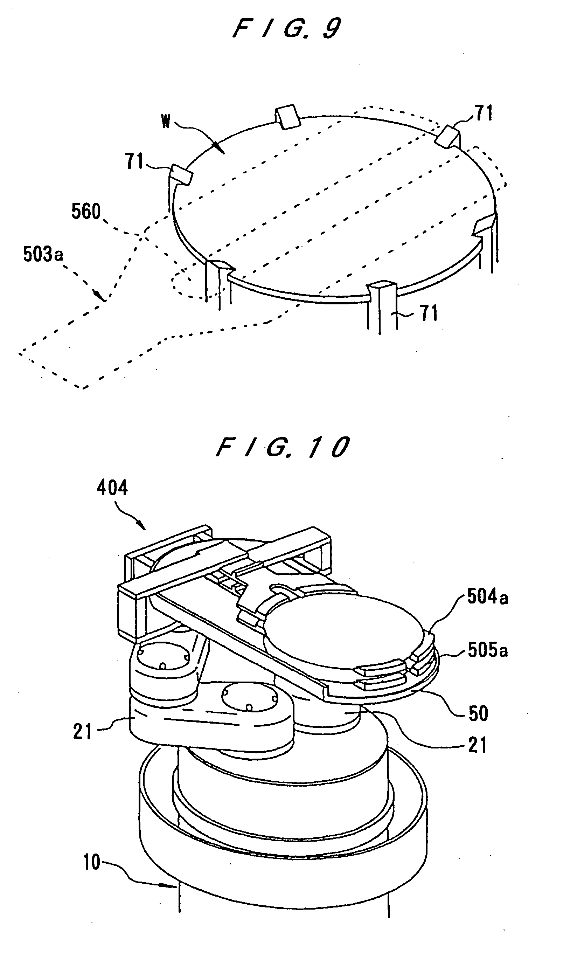

Another advantage is that the presence of the cut-out 560 facilitates transferring of the wafer W to and from a wafer rotation device having clamp mechanism for holding the wafers W. For example, the secondary cleaning device 204 and the spin dryers 206 shown in Figure 1 require the wafer W to be held and rotated in a clamp such as the one shown in Figure 9. Such an operation can be performed by clamping the outer periphery of the wafer W with concentric hooks 71 shown in Figure 9 so that the wafer W may be rotated. This configuration of the hand member 503a enables it to be placed under the clamped wafer W by locating the hook 71 within the cut-out 560 of the hand member 503a while the wafer W is being clamped in the set of hooks 71.

The protrusion section 561 on the handle portion 551 serves as a splash guard to prevent liquid droplets splashing from the wafers W to reach the robot body while the hand member 503a is handling the wafer W. In this embodiment, because of the presence of the pan member 50 provided below the hand member 503a attached to the arm assembly 21 of the transport apparatus 402, there is no danger of the robot body becoming wet even if the droplets fall from the hand member 503a.

It should also be noted that although a plurality of hand members 502-505 are provided on each of the two transport apparatuses 402, 404, the number of hand members is chosen for each application, and only one hand member may be sufficient in some cases. It would be equally clear that the number, attachment position and shape of the waterproof pan members are not limited by the examples shown in the embodiments. Although the waterproof pan is fixed to the robot body in the embodiments, it may be constructed movable to correspond with the hand member's movement. Flexibility is permitted within the objective to achieve splash protection for the robot body and articulating joints and other critical components of the robotic transport apparatus.

It should be noted also that although the applications of the hand member were illustrated in association with the polishing application, it is obvious that the transport apparatus disclosed in the present invention can be generally applied equally to other semiconductor processing applications, including photolithography, other types of cleaning facilities and sputtering equipment.

### SUMMARY OF THE INVENTION

1. A robotic transport apparatus for transporting workpieces from one processing site to other processing site, comprising:
   a robot body; an arm assembly extendably attached to said robot body; a workpiece holding section attached to said arm assembly; and a pan member for waterproof of said robot body, said pan member having a projection area not smaller than that of said workpiece holding section and being provided between said workpiece holding section and said robot body.
2. A robotic transport apparatus, wherein said arm assembly is provided with a connection member for connecting said arm assembly with said workpiece holding section in a manner to bypass said pan member.
3. A robotic transport apparatus, wherein said pan member has a projection area to cover an upper surface of said robot body.
4. A robotic transport apparatus, wherein said pan member has a projection area to cover all of joint sections of said arm assembly.
5. A robotic transport apparatus, wherein each of said robot body is provided with not less than two arm assemblies.
6. A robotic transport apparatus, wherein said pan member is provided with drainage pipe for removing waste liquid.
7. A robotic transport apparatus, wherein said pan member is supported on an upper surface of said robot body, and a second pan member is provided on the outer periphery of said robot body, and said drainage pipe is inserted in said second pan member.
8. A robotic transport apparatus, wherein said pan member comprises a drainage surface descending towards said drainage pipe.
9. A robotic transport apparatus, wherein said robot body is movable along a transport path.
10. A robotic transport apparatus, wherein said pan member is shaped elongated in a direction orthogonal to said transport path.
11. A robotic transport apparatus, wherein a drainage trench having a drainage pipe for removing waste liquid from said pan member is provided along said transport path.
12. A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration for receiving workpieces, and said receiving section comprises a contact surface for contacting lower peripheral surfaces of said workpieces, and a bottom section surface, disposed on an inner side of and at a lower level than said contact surface, and a separation distance between said contact surface and said bottom section surface is selected to be not less than a maximum diameter of a droplet formed by a liquid abiding at said bottom section surface.
13. A robotic transport apparatus, wherein said workpieces comprise a semiconductor substrate material, and said waste liquid comprises abrasive liquids.
14. A robotic transport apparatus, wherein said workpieces comprise a semiconductor substrate material, and said waste liquid comprises cleaning liquids.
15. A robotic transport apparatus, wherein said separation distance is not less than 3.0 mm.
16. A robotic transport apparatus, wherein said bottom section surface includes a drainage opening.
17. A robotic transport apparatus, wherein said drainage opening has a cut-out open to the exterior.
18. A robotic transport apparatus, wherein said receiving section is surrounded with a guide portion having a tapered guide surface.
19. A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration, and said receiving section is surrounded by a guide portion having a tapered guide surface.
20. A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration for receiving workpieces, and said receiving section comprises a contact surface for contacting lower peripheral surfaces of said workpieces and a bottom section surface, disposed on an inner side of and at a lower level than said contact surface, and said bottom section surface is slanted to form a tapered drainage surface for draining liquid.
21. A robotic transport apparatus for transporting workpieces from one processing site to other processing site, comprising: a robot body; a workpiece holding section for holding said workpiece; and a pan member for waterproof of said robot body, said pan member having a projection area not smaller than that of said workpiece holding section and being provided between said workpiece holding section and said robot body.
22. A polishing apparatus comprising: a polishing section for polishing workpieces; a cleaning section for cleaning said polished workpieces, a storage section for storing workpieces; and a transport apparatus for transporting workpieces from one processing section to another processing section,
   wherein said transport apparatus comprises a robot body; a workpiece holding section for holding said workpiece; and a pan member for waterproof of said robot body, said pan member having a projection area not smaller than that of said workpiece holding section and being provided between said workpiece holding section and said robot body.

## Claims

1. A robotic transport apparatus for transporting workpieces from one processing site to other processing site, comprising:
a robot body; an arm assembly extendably attached to said robot body; a workpiece holding section attached to said arm assembly; and a pan member for waterproof of said robot body, said pan member having a projection area not smaller than that of said workpiece holding section and being provided between said workpiece holding section and said robot body.

2. A robotic transport apparatus according to claim 1, wherein said arm assembly is provided with a connection member for connecting said arm assembly with said workpiece holding section in a manner to bypass said pan member.

3. A robotic transport apparatus according to claim 1, wherein said pan member has a projection area to cover an upper surface of said robot body.

4. A robotic transport apparatus according to claim 1, wherein said pan member has a projection area to cover all of joint sections of said arm assembly.

5. A robotic transport apparatus according to claim 1, wherein each of said robot body is provided with not less than two arm assemblies.

6. A robotic transport apparatus according to claim 1, wherein said pan member is provided with drainage pipe for removing waste liquid,
and/or wherein preferably
said pan member is supported on an upper surface of said robot body, and a second pan member is provided on the outer periphery of said robot body, and said drainage pipe is inserted in said second pan member,
and/or wherein preferably
said pan member comprises a drainage surface descending towards said drainage pipe,
and/or wherein preferably
said robot body is movable along a transport path,
and/or wherein preferably
said pan member is shaped elongated in a direction orthogonal to said transport path,
and/or wherein preferably
a drainage trench having a drainage pipe for removing waste liquid from said pan member is provided along said transport path.

7. A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration for receiving workpieces, and said receiving section comprises a contact surface for contacting lower peripheral surfaces of said workpieces, and a bottom section surface, disposed on an inner side of and at a lower level than said contact surface, and a separation distance between said contact surface and said bottom section surface is selected to be not less than a maximum diameter of a droplet formed by a liquid abiding at said bottom section surface.

8. A robotic transport apparatus according to claim 12, wherein said workpieces comprise a semiconductor substrate material, and said waste liquid comprises abrasive liquids,
and/or wherein preferably
said workpieces comprise a semiconductor substrate material, and said waste liquid comprises cleaning liquids,
and/or wherein preferably
said separation distance is not less than 3.0 mm,
and/or wherein preferably
said bottom section surface includes a drainage opening,
and/or wherein preferably
said drainage opening has a cut-out open to the exterior,
and/or wherein preferably
said receiving section is surrounded with a guide portion having a tapered guide surface.

9. A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration, and said receiving section is surrounded by a guide portion having a tapered guide surface.

10. A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration for receiving workpieces, and said receiving section comprises a contact surface for contacting lower peripheral surfaces of said workpieces and a bottom section surface, disposed on an inner side of and at a lower level than said contact surface, and said bottom section surface is slanted to form a tapered drainage surface for draining liquid.

11. A robotic transport apparatus for transporting workpieces from one processing site to other processing site, comprising: a robot body; a workpiece holding section for holding said workpiece; and a pan member for waterproof of said robot body, said pan member having a projection area not smaller than that of said workpiece holding section and being provided between said workpiece holding section and said robot body.

12. A polishing apparatus comprising: a polishing section for polishing workpieces; a cleaning section for cleaning said polished workpieces, a storage section for storing workpieces; and a transport apparatus for transporting workpieces from one processing section to another processing section,
wherein said transport apparatus comprises a robot body; a workpiece holding section for holding said workpiece; and a pan member for waterproof of said robot body, said pan member having a projection area not smaller than that of said workpiece holding section and being provided between said workpiece holding section and said robot body.

13. A robotic transport apparatus for transporting workpieces from one processing site to other processing site, comprising: a robot body; an arm assembly extendably attached to said robot body; a workpiece holding section attached to said arm assembly

## Amended claims

### Amended claims in accordance with Rule 86(2) EPC.

**1.** A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration for receiving workpieces, and said receiving section comprises a contact surface for contacting lower peripheral surfaces of said workpieces, and a bottom section surface, disposed on an inner side of and at a lower level than said contact surface, and a separation distance between said contact surface and said bottom section surface is selected to be not less than a maximum diameter of a droplet formed by a liquid abiding at said bottom section surface.

**2.** A robotic transport apparatus according to claim 1, wherein said workpieces comprise a semiconductor substrate material, and said waste liquid comprises abrasive liquids.

**3.** A robotic transport apparatus according to claim 1, wherein said workpieces comprise a semiconductor substrate material, and said waste liquid comprises cleaning liquids.

**4.** A robotic transport apparatus according to claim 1, wherein said separation distance is not less than 3.0 mm.

**5.** A robotic transport apparatus according to claim 1, wherein said bottom section surface includes a drainage opening.

**6.** A robotic transport apparatus according to claim 1, wherein said drainage opening has a cut-out open to the exterior.

**7.** A robotic transport apparatus according to claim 1, wherein said receiving section is surrounded with a guide portion having a tapered guide surface.

**8.** A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration, and said receiving section is surrounded by a guide portion having a tapered guide surface.

**9.** A robotic transport apparatus for transporting workpieces from one processing site to other processing site, comprising: a robot body; an arm assembly extendably attached to said robot body; and a workpiece holding section attached to said arm assembly, wherein said workpiece holding section has a receiving section of a recessed configuration for receiving workpieces, and said receiving section comprises a contact surface for contacting lower peripheral surfaces of said workpieces and a bottom section surface, disposed on an inner side of and at a lower level than said contact surface, and said bottom section surface is slanted to form a tapered drainage surface for draining liquid.
